Europäisches Patentamt

European Patent Office

Office européen des brevets

(11) Publication number: **0 319 122 B1**

(12) **EUROPEAN PATENT SPECIFICATION**

(45) Date of publication of patent specification: 27.10.93   (51) Int. Cl.5: **C30B 25/02**, C23C 16/44

(21) Application number: **88307330.6**

(22) Date of filing: **08.08.88**

The file contains technical information submitted after the application was filed and not included in this specification

(54) **Apparatus and its use for producing semiconductors.**

(30) Priority: **30.11.87 JP 304206/87**
**30.11.87 JP 304209/87**

(43) Date of publication of application:
**07.06.89 Bulletin 89/23**

(45) Publication of the grant of the patent:
**27.10.93 Bulletin 93/43**

(84) Designated Contracting States:
**DE FR GB NL**

(56) References cited:
**EP-A- 0 211 292**
**EP-A- 0 319 121**
**GB-A- 2 162 367**
**US-A- 3 916 822**

**PATENT ABSTRACTS OF JAPAN, vol. 8, no. 221 (E-271)[1658], 9th October 1984; & JP-A-59 104 117**

(73) Proprietor: **DAIDOUSANSO CO., LTD.**
**72-1 Unagidani nakanocho**
**Minami-Ku**
**Osaka-shi Osaka 542(JP)**

(72) Inventor: **Yoshino, Akira**
**2-30-13, Nishiyamadai**
**Osakasayama-shi Osaka 589(JP)**
Inventor: **Okumura, Kenji**
**2-134-2 Aho**
**Matsubara-shi Osaka 580(JP)**
Inventor: **Ohnishi, Toshiharu**
**3-3-20-504 Takabedai**
**Tondabayashi-shi Osaka 584(JP)**
Inventor: **Kuromiya, Shigeru**
**3-2-21, Tezukayamanaka**
**Sumiyoshi-ku**
**Osaka-shi Osaka 558(JP)**

(74) Representative: **Marlow, Nicholas Simon et al**
**Reddie & Grose**
**16, Theobalds Road**
**London WC1X 8PL (GB)**

## Description

This invention relates to an apparatus and its use for producing semiconductors of the type in which Group III-V compound semiconductor layers are deposited in a vacuum chamber, such as a vacuum chemical epitaxy (VCE) system.

In recent years, the demand for compound semiconductors especially Group III-V compounds (e.g. GaAs) has been growing because of their being superior in performance characteristics to the conventional silicon semiconductors. For the production of such Group III-V compound semiconductors, there are known, among others, the so-called molecular beam epitaxy (MBE) process which comprises causing atoms required for a compound to be epitaxy grown to evaporate from a solid material using a heat gun and causing them to collide, in the molecular beam form, against a substrate in an ultrahigh vacuum to thereby cause growth of a film of said material on said substrate, and the so-called metal organic chemical vapor desposition (MOCVD) process which comprises introducing the vapor of a methyl-metal or ethyl-metal compound into a reaction chamber at atmospheric pressure or under reduced pressure by means of a carrier gas such as $H_2$, allowing said vapor to mix with a Group V metal hydride and allowing the reaction therebetween to take place on a heated substrate for crystal growth.

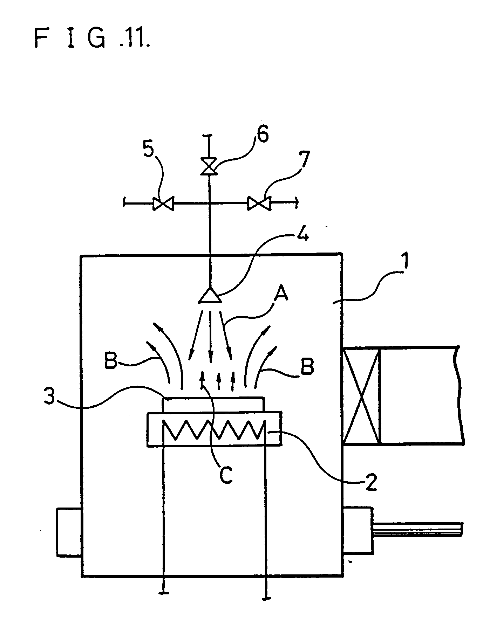

However, the MBE process has a problem in that it is not suited for large-scale production, hence can hardly meet the needs of the market. The MOCVD process also has a problem in that the reactant gases are expensive and because of the growth mechanism, the efficiency of utilization of reactant gases is low, although said process is higher in production capacity than the above-mentioned MBE process. It is therefore difficult to employ the MOCVD process for the production of semiconductors for use in other fields than some special fields where high costs do not matter. Furthermore, since a large quantity of unreacted gas, which is toxic, is produced because of the efficiency of reactant gas utilization being low, as mentioned above, and since a carrier gas is used for gasifying and carrying the Group III compound, which has a low vapor pressure, and this constitutes an additional waste gas portion, a toxic waste gas is discharged in large quantities, and this fact leads to waste gas disposal problems. Apparatus so far in use for such MOCVD process can be schematically illustrated by Fig. 11. Thus, a substrate 3 is mounted on a heater 2 disposed in a vacuum chamber 1, and a gaseous compound mixture for semiconductor deposition is fed toward the substrate 3 the directions indicated by the arrows A from a nozzle 4 disposed in the upper part of said vacuum chamber 1. In such apparatus, the vacuum chamber 1, which has a large capacity, is filled with a gaseous compound (reactant gas) mixture for each treatment run and, after treatment, the gaseous compound mixture is discharged as a waste gas. The waste gas contains unreacted gases, which have not been involved in semiconductor deposition, in large quantities and, accordingly, the reactant gas utilization efficiency is low. In the above-mentioned apparatus, the substrate 3 is placed on the heater 2 and heated from the under surface. Thermal convection thus takes place over the substrate, as shown by the arrows B, and heat is dissipated from the substrate 3 heated by the heater 2 to the vicinity of the upper surface of the substrate 3, as shown by the arrows C. As a result, the flow of the gaseous compound mixture fed from the nozzle 4 is disturbed by the forcing-up effect of the above-mentioned thermal convection current (arrows B) and heat dissipated (arrows C), so that uniform film growth on the upper surface of the substrate 3 cannot take place any longer. Therefore, it is a serious disadvantage of the apparatus mentioned above that the product semiconductor films (semiconductor layers) cannot have a smoothly finished surface. This disadvantage is further aggravated by the fact that Ga•As particle flags formed by contact and reaction, in the gaseous atmosphere, of the reactants that have failed to arrive at the surface of the substrate 3 due to the above-mentioned thermal convection (arrows B) float in the gaseous atmosphere and deposit on the semiconductor film at random. Furthermore, in the above-mentioned apparatus, any change in the kind of feed gas is effected by operation of a plurality of valves 5, 6 and 7 for respective gas feeding pipes connected to the above-mentioned nozzle 4. For formation of a plurality of semiconductor layers differing in kind, frequent change-over operation of the valves 5, 6 and 7 is required. This disadvantageously means a low operation efficiency. It is a further problem that the compound or compounds used in the previous series of runs remain in the nozzle 4 and behave as impurities which make it difficult to obtain semiconductors of good quality.

JP-A-59104117 discloses an apparatus and method for depositing a thin film on a substrate. The substrate is heated, by a heater above the substrate, in a vacuum chamber into which reactant gas is introduced from below the level of the substrate. Gas is exhausted from the chamber through a toroidal exhaust pipe.

US-A- 3 916 822 discloses an apparatus and method for depositing a thin film on a substrate, in which reactant gas reaches the downwardly directed surface of the substrate, in a vacuum chamber, by convection. A radiation shield is provided below the substrate to minimise convection currents in the vicinity of the substrate.

Accordingly, it has been desired to provide a process for producing good-quality semiconductors having a smooth semiconductor layer surface efficiently by combining the advantages of the MBE process and those of the MOCVD process.

The present invention provides an apparatus for producing semiconductors by a process in which semiconductor layers are deposited on a surface of at least one substrate disposed within a vacuum chamber in a vacuum chemical epitaxy system. The apparatus comprises a reaction chamber; a substrate holder in the top wall of the reaction chamber for holding a substrate so that the face of the substrate is directed into the reaction chamber; a feed tube for feeding a first reactant gas for semiconductor layer deposition to the reaction chamber from below towards the substrate; and a heater for heating the substrate disposed above the substrate holder. A vacuum chamber, which can be evacuated to a high degree, is disposed around the reaction chamber to form a double structure. The reaction chamber is in fluid communication with the vacuum chamber through exhaust ports in the walls of the reaction chamber. The apparatus further comprises a mixing chamber disposed below the reaction chamber and in communication therewith through openings in the adjacent walls of the two chambers, and an inlet tube for supplying a second reactant gas to the mixing chamber.

The present invention further provides the use of such an apparatus for producing semiconductors. The use may be characterised by heating, cooling or depositing the semiconductor layers in a plurality of independent zones within the vacuum chamber, transferring the substrate to another zone stepwise to be able to perform a different treatment and whereby a plurality of substrates may be treated simultaneously, each in a separate zone.

In the accompanying drawings,

Fig. 1(a) illustrates, in vertical section, an embodiment of the semiconductor production apparatus according to the invention,

Fig. 1(b) illustrates, in plan view, the heater of said apparatus,

Fig. 2 is an enlarged view of part of Fig. 1 (a),

Fig. 3 illustrates, in perspective, the reaction chamber thereof,

Fig. 4 illustrates, in planar section, the apparatus inclusive of a substrate feeding apparatus,

Fig. 5 illustrates, in plan view, the state of distribution of nozzle openings and of feeding pipes in the reaction chamber,

Fig. 6 illustrates, in plan view, another embodiment of the invention, which is suited for continuous production of semiconductors,

Fig. 7 is a vertical sectional view of said embodiment as seen along A-A' shown in Fig. 6,

Fig. 8 illustrates, in plan view, the rotating disc block used in said embodiment,

Fig. 9 illustrates a MESFET epitaxy layer deposition process,

Fig. 10 illustrates a HEMT epitaxy layer deposition process, and

Fig. 11 illustrates, in cross section, a conventional apparatus.

In use,

the vacuum chamber is evacuated to a high degree of vacuum to increase the mean free path for reactant gas molecules and the gas molecules are allowed to collide against the substrate in the form of molecular beams. As a result, the reactant gas utilization efficiency can be much increased. Furthermore, the vacuum chamber is maintained at a high degree of vacuum and, therefore, even a Group III compound which is low in vapor pressure can be gasified there. Consequently, the use of a carrier gas for gasifying and carrying the Group III compound is no more necessary, and the quantity of-waste gas to be treated for disposal becomes minimal.

Since heating is done from above and feeding the reactant gases is done from below towards the substrate, thermal convection is not generated below the substrate but above it. Therefore, the reactant gases fed from below the substrate arrive at the surface of the substrate without being influenced by the thermal convection to form semiconductor layers with very good surface smoothness on the substrate surface. In the case that the vacuum chamber is divided into plural independent zones, heating, cooling means are installed in a defined zone, at the same time, a heater to heat the substrate from above and reactant gas feeding means to feed the reactant gases towards the substrate from below are disposed in other defined zones, the substrate is transferred to said plural independent zones stepwise to perform different treatments in each zone, it is possible to produce semiconductors continuously, so that production efficiency is increased very much in addition to the effect mentioned above. It is further possible to use different kinds of reactant gases in each zone because the vacuum chamber is divided into plural independent zones. Therefore, admixture of different kinds of reactant gases to be impurity portion does not occur, the good quality of obtained semiconductors is maintained. Additionally, the reactant gas utilization efficiency is much increased since the reactant gases are fed to the independent zone of which the content is small compared with the vacuum chamber.

The following examples will illustrate the invention in more detail.

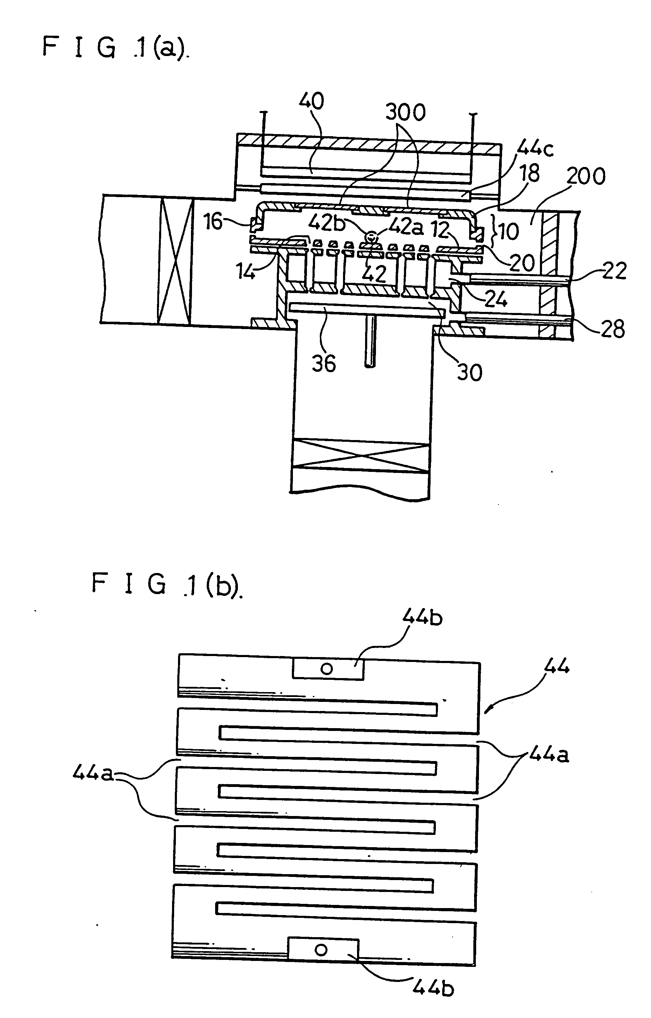

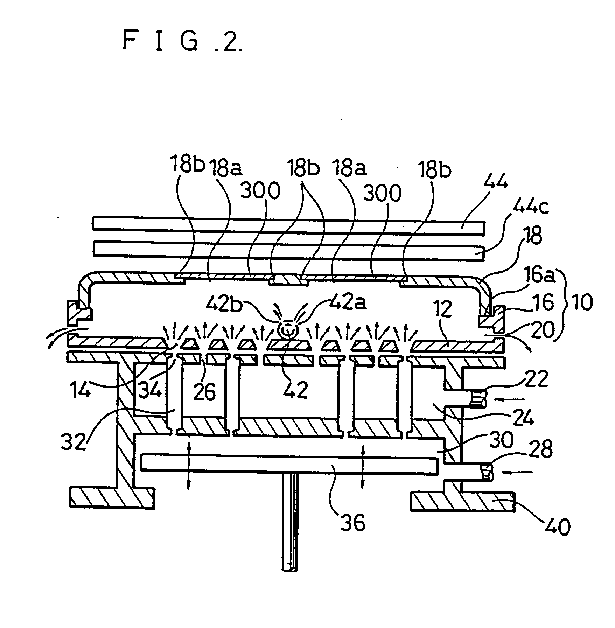

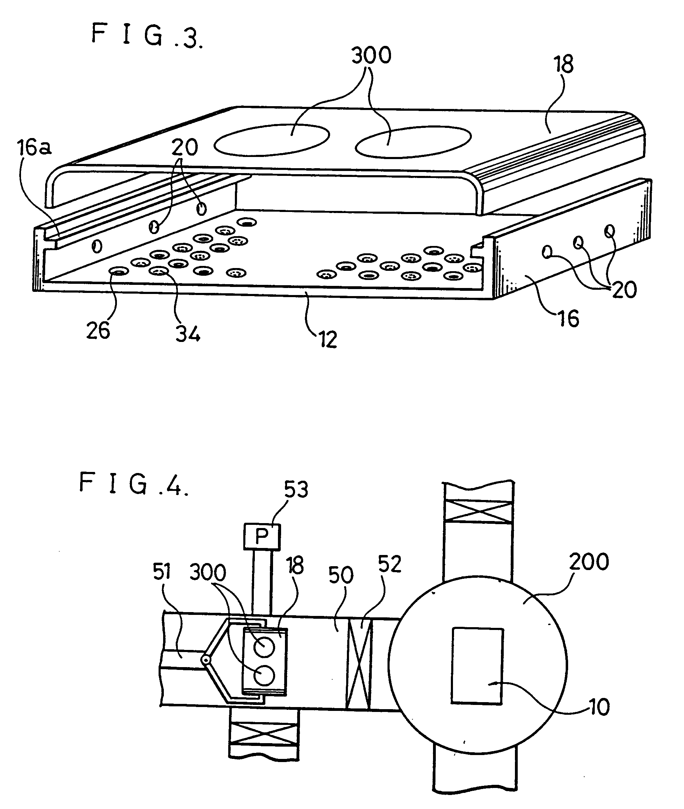

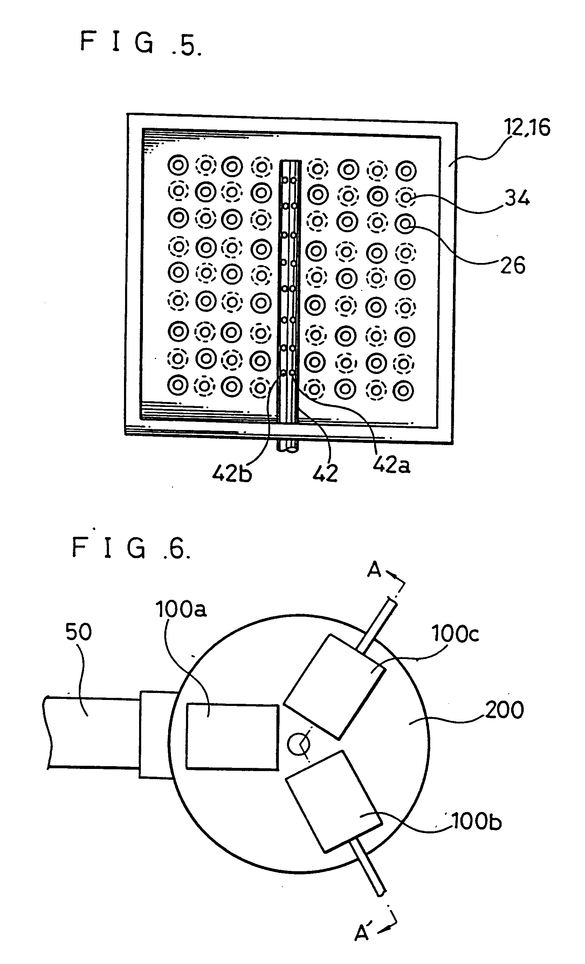

Figs. 1-4 illustrate an embodiment of the semiconductor production apparatus according to the invention. In these figures, the reference numeral 200 indicates the vacuum chamber of a vacuum chemical epitaxy system. The vacuum chamber 200 has a reaction chamber 10 therein, which is formed by a tetragonal base plate 12, surrounding walls 16 rising from the circumference of said base plate and a top plate 18 placed, slidably in one direction, on the upper edges of the surrounding walls 16. The top plate 18 has, in the middle portion thereof, two openings 18a. A disc-form GaAs substrate 300 of which the surface faces below is detachably mounted on the holding part 18b on the circumference of each opening 18a. The right and left (in the figures) ends of the top plate 18 are curved downward, and the curved portions are slidably supported on slideways 16a provided inwardly on the right and left (in the figures) opposed wall 16 out of the four surrounding walls 16, so that the top plate 18 can slide toward a substrate exchange chamber 50 (Fig. 4) connected to the vacuum chamber 200. Referring to Fig. 4, a magic hand 51 can move the top plate 18, with the curved portions thereof nipped by said hand, from the substrate exchange chamber 50 through a valve 52 to the vacuum chamber 200 and can place the top plate 18 just on the reaction chamber 10. A vacuum pump 53 evacuates the substrate exchange chamber 50 prior to opening of the valve 52 to a vacuum approximately equal to that in the vacuum chamber 200. The surrounding walls of the reaction chamber 10 have exhaust ports 20 at certain given intervals around the same for discharge of unreacted or excess reactant gas mixture from the reaction chamber into the vacuum chamber 10. The total area of these exhaust ports 20 is preferably about 4% of the surface area of the top plate 18 of the reaction chamber 10. The base plate 12 has nozzle openings 14 having a diameter of 3.2 mm, for instance, with the diameter being increased on the upper side, and perforated just below both substrates 300 and at regular intervals (e.g. 25.4 mm), said nozzle openings having a direction perpendicular to the substrate 300 and being in communication with openings 26 or 34 on the ceiling of a first mixing chamber 24 disposed below the reaction chamber 10. As shown in Fig. 5, the openings 26 are disposed alternately with the same number of the openings 34. Each opening 26 is in communication with the first mixing chamber 24, whereas each opening 34 is in communication with a second mixing chamber 30 via a duct 32 which passes through the first mixing chamber 24. The first mixing chamber 24 is in communication with a starting material inlet tube 22 passing through one side wall, as shown in Fig. 2. Said starting material inlet tube 22 serves for introducing into the first mixing chamber 24 of a Group III compound (reactant gases) such as trimethylgallium (TMGa) or triethylgallium (TEGa) or of an n-type or p-type dopant either alone or in admixture with such Group III compound. The compound or compounds, after uniform mixing in the first mixing chamber 24, are fed, via the openings 26 and nozzle openings 14, to the reaction chamber in a state of uniform distribution toward the respective substrates 300 positioned above the nozzle openings. The second mixing chamber 30 has an opening in the lower part, and an exhaust valve 36, suitably a poppet valve, is disposed displaceably in said opening for opening or closing said opening. Said second mixing chamber 30 is in communication, through one side wall thereof, with a starting material inlet tube 28. Through said inlet tube 28, an n-type or p-type dopant or a Group III compound such as triethylaluminum (TEA1) enters the second mixing chamber 30. The Group III compound, after mixing to a homogeneous state in the second mixing chamber 30 and the ducts 32, enters the reaction chamber in a state of uniform distribution via the openings 34 and the nozzle openings 14 toward the substrates 300. The ducts 32 mentioned above work as the reactant gas flow registance and give an effect of mixing to serve for improved mixing of reactant gases in the first mixing chamber 24. The first and second mixing chambers 24, 30 are made of a stainless steel block formed integrally and are supported by a stainless steel support member 40. As shown in Fig. 5, a feeding tube 42 for feeding a Group V compound such as $AsH_3$ to the reaction chamber 10 is disposed on the base plate 12 in a position such that it splits the openings 26 and 34 into equal (in the figure, right and left) halves. Said feeding tube has a plurality of holes 42a and 42b at certain definite intervals and in two rows (right and left), whereby the Group V compound can be fed to the reaction chamber 10 in a uniformly distributed state. A heater 44 is disposed above the top plate 18 of the reaction chamber 10, with a leveling plate 44c located between said heater and said top plate. The substrates 300 are thus heated mainly by radiant heat from the above to a temperature sufficient for semiconductor compound deposition on the surface thereof without exposing the forming semiconductor layers to thermal convection and the like influences. As a result, semiconductor layers can deposit on the substrates 300 uniformly. As shown in Fig. 1 (b), the heater 44 may be made by cutting a carbon graphite sheet to make alternate stripe-form cuttings 44a, and fitting the sheet with electrodes 44b on both ends of the sheet. While uniform planar heating is Possible with such heater 44 alone, the use of the heat leveling plate 44c disposed below the heater 44 can make the planar heating more uniform.

In operation for MESFET epitaxy layer deposition, the reaction chamber 10 is fitted with the top plate 18 with the substrates 300 (the surfaces face below respectively.) thereon, as shown in Fig. 1. Then, the vacuum chamber 200 is evacuated to a vacuum of $1,33 \times 10^{-5}$ Pa $(10^{-7}$ torr) and the heater 44 is electrically loaded so that the heater 44 can generate heat and raise the atmospheric temperature to 650°C. In that state, the substrates 300 are heated for about 15 minutes. Thereafter, a Group III compound, such as trimethylgallium (TMGa) or triethylgallium (TEGa), is fed from the starting material inlet tube 22 of the reaction chamber 10 to the first mixing chamber 24 and mixed there uniformly and then enters the reaction chamber via the nozzle openings 14 in a uniformly distributed state toward the surface of the substrates 300. At the same time, a Group V compound, such as $AsH_3$ or an alkylarsine, for example triethylarsine (TEAs), is fed to the feeding tube 42. An excessive amount of the Group V compound enters the reaction chamber 10 through the holes 42a and 42b. As a result, the Group V compound thus fed to the reaction chamber 10 flows, together with the above-mentioned Group III compound (and so forth), dispersedly along the surface of the substrates 300 toward the exhaust ports 20. During the flow, $AsH_3$ or TEAs is thermally decomposed to give $As_2$, which, together with gallium from the above-mentioned gallium compound, comes into contact with the surface of the substrates 300 and deposits on said surface in the form of an undoped gallium arsenide (GaAs) layer or the like. The unreacted compounds that has not come into contact with the substrates 300 leave the reaction chamber via the exhaust ports 20 and enters the vacuum chamber 200, which they then leave laterally under the action of an exhaustion means. It is preferable to allow deposition of the above-mentioned GaAs layer at a growth rate of about $2\mu$m per hour and to a thickness of about $10^3$nm $(10^4$ Å). In this case, the concentration of inpurity portion in said undoped GaAs layer should preferably be not higher than $1 \times 10^{15}$ atoms per square centimeter. Then, an n-type dopant, either alone or in admixture with the above-mentioned Group III or V compound, is fed to the reaction chamber 10 from the second mixing chamber 30 so that an n-type active layer can deposit on the surface of said undoped GaAs layer. This n-type active layer is preferably caused to deposit at a growth rate of about 2 $\mu$m per hour and to a thickness of about $2.10^2$nm $2 \times 10^3$ Å). A suitable n-type dopant concentration in said active layer is about $2 \times 10^{17}$ atoms per square centimeter. Thereafter, all the gas supplies are discontinued and the system is maintained in that state for about 15 minutes. Then, the substrates 300 are cooled and taken out of the reaction chamber 10 (hence, from the vacuum chamber 200) in the following manner. Thus, the vacuum in the substrate exchange chamber 50 is increased to a level which is approximately equal to that in the vacuum chamber 200, the valve 52 is then opened, the magic hand 51 is stretched so as to hold the top plate 18 (with the substrates 300) of the reaction chamber 10 and then put back in that state, whereby the top plate 18 is slided off from the walls -16 of the reaction chamber 10 and received by the substrate exchange chamber 50. The substrates 300 taken out are fitted with signal source electrodes, drain electrodes and gate electrodes by known means. In this way, Group III-V compound semiconductors having a uniform MESFET semiconductor layer can be obtained.

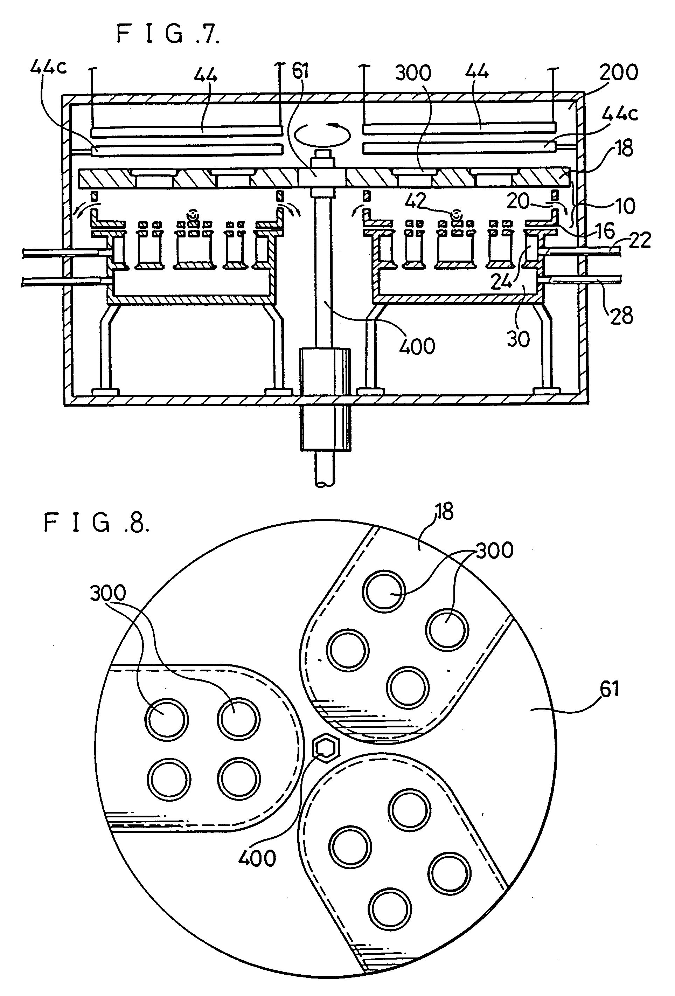

Figs. 6-8 illustrate another embodiment of the invention, which is suited for continuous semiconductor production. In this apparatus, vacuum chamber 200, which is round, is divided into three zones 100a, 100b and 100c and each zone has a reaction chamber 10 which is the same as that mentioned hereinabove. The top plate 18 of each reaction chamber 10 is mounted detachably on the corresponding arch-shaped cut made in a rotatable disc 61 (Fig. 8) approximately equal in size to the vacuum chamber 200. Thus, the top plate 18 is approximately equal in shape to the above-mentioned arch-shaped cut 60 and is supported detachably by the supporting part formed on the circumferential edge of said arch-shaped cut 60. The rotatable disc 61 with three top plates 18 is slowly rotated around a rotatable shaft 400 positioned at the center of the vacuum chamber 200 after each operational run in a manner such that the top plate 18 of one reaction chamber 10 is shifted to the position of the next reaction chamber 10. The surrounding walls 16 of said each reaction chamber 10 have exhaust ports 20 around the same at certain given intervals. The reaction chamber 10 in the zone 100a which is close to the substrate exchange chamber 50 serves for preheating the substrate 300, the reaction chamber 10 in the zone 100b serves for undoped layer growth, and the reaction chamber 10 in the zone 100c serves for n-type active layer growth.

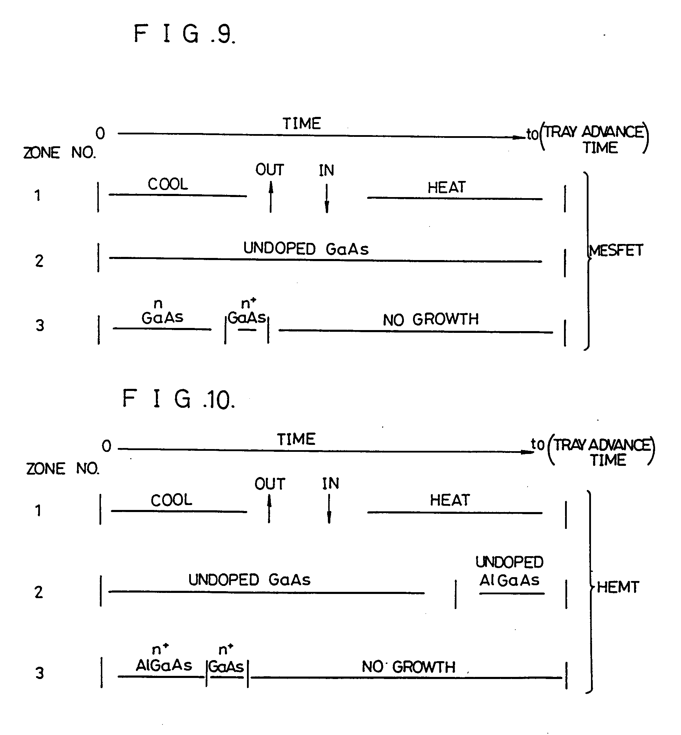

In operation, 1152 semiconductors can be produced weekly when four substrates 300 are placed, in the state that the surfaces respectively face downward, on each of the top plates 18 in the zones 100a, 100b and 100c and the apparatus is operated in a two-shift system a day. Referring to Fig. 9 (MESFET epitaxy layer deposition process flowchart) and Fig. 2, the mode of operation will be described in more detail. First, the vacuum chamber 200 is evacuated to a vacuum of $1,33 \times 10^{-5}$ Pa $(10^{-7}$ torr) and the heater 44 is electrically loaded for heat generation to raise the atmosphere temperature to 650°C. In that state, the top plate 18 with the substrates 300° is mounted on that arch-shaped cut 60 of the rotating disc 61 which corresponds to the first zone by stretching the magic hand 51 from the substrate exchange chamber 50. The substrates 300 are heated there for about 15 minutes and then transferred to the reaction chamber 10 of the second zone 100b by rotating the rotating disc 61 together with said top plate 18 and substrates 300. In the reaction chamber 10 in the second zone, a Group III compound, such as trimethylgallium (TMGa) or triethylgallium (TEGa), is fed to the first mixing chamber 24, as mentioned above for the first apparatus. The uniformly mixed gas of said Group III compound then enters the reaction chamber in a uniformly distributed state through the nozzle openings 14 toward the substrates 300. At the same time, a Group V compound such as $AsH_3$ or an alkylarsine, for example triethylarsine (TEAs) is fed to the feeding tube 42 for feeding said compound in excess to the reaction chamber 10 via the holes 42a and 42b. An undoped gallium arsenide (GaAs) layer is thereby deposited on the surface of the substrate 300. After the above treatment, the substrates 300, together with the top plate 18, is transferred to the reaction chamber 10 in the third zone 100c. In this zone, an n-type dopant, together with a Group III compound, is fed to the reaction chamber 10 from the first mixing chamber 24, or the dopant alone is fed to the reaction chamber 10 from the second mixing chamber 30, to thereby cause deposition of an n-type active layer on the surface of the above-mentioned undoped GaAs layer. Thereafter, feeding of all the gases including the above-mentioned Group III compound is suspended, and the reaction chamber is maintained in that state for about 15 minutes. Then, the top plate 18 is further rotated such that the substrates 300 treated in the above manner return to the reaction chamber 10 in, the first zone 100a. After cooling there, the substrates 300 are taken out therefrom together with the top plate 18 and transferred to the substrate exchange chamber 50 by means of the magic hand 51. This apparatus can produce semiconductors continuously by repeating the above series of operations. In this case, the above three treatments are performed simultaneously in the corresponding reaction chambers 10. The time required for such series of treatments amounts to about 1.5 hours, made up as follows: about 15 minutes each for heating and cooling in the first zone 100a, about 30 minutes for undoped layer growth in the second zone 100b, and about 15 minutes for n-type active layer growth and about 15 minutes of no growth period (without feeding of any gaseous compound) in the third zone 100c. Therefore, 1.5 hours is required for processing twelve substrates 300. Hence, when the apparatus is operated continuously by working in two shifts a day, it can produce 1152 semiconductors weekly.

Fig. 10 shows a HEMT epitaxy layer deposition process flowchart. According to this chart, HEMT epitaxy layers can be grown in the second and third zones 100b and 100c by feeding, in the same manner as mentioned above, an A1-containing Group III compound, such as triethylaluminum, from the second mixing chamber 30 (Fig. 7). In this case, the substrates 300 are first heated in the first zone 100a in the same manner as mentioned above. Then, in the second zone 100b, a GaAs layer having a dopant concentration of not more than $1 \times 10^{15}$ atoms per square centimeter and a thickness of about $10^3$ nm ($10^4$ Å) is caused to deposit by using gaseous Group III and Group V compounds and, further, an undoped $A1_zGa_{1-z}As$ layer is caused to deposit on the above-mentioned GaAs layer to a thickness of 3-10 nm (30-100 Å) by feeding an A1-containing compound from the second mixing chamber 30 in addition to the above-mentioned gas. In the third zone 100c, an n-type dopant is fed in addition to the above-mentioned gas for causing an n+-type $A1_zGa_{1-z}As$ layer to grow on the above-mentioned $A1_zGa_{1-z}As$ layer to a thickness of 50 nm (500 Å). In that case, the number z has a value of 0.1-0.9, preferably 0.2-0.3. Then, the exhaust valve (not shown) installed with a starting material inlet tube 28 for the second mixing chamber 30 is closed and the feeding of the A1-containing compound alone among the gas components is discontinued, so that an n-type GaAs layer containing the n-type dopant is caused to deposit to a thickness of about $10^2$ nm ($10^3$ Å). Thereafter, in the same manner as mentioned above, the substrates 300 having a semiconductor layer formed thereon are cooled in the first zone 100a, taken out of the semiconductor production apparatus and fitted with signal source electrodes and so forth. In this way, HEMT semiconductors can be produced. The time required in this case is substantially the same as mentioned above.

In the apparatus mentioned above, the distance from the nozzle openings 14 to the substrates 300 is adjusted such that said distance is shorter than the mean free path (average distance traveled by a, gas molecule until it collides with another molecule) for gas molecules of the Group III compound in a vacuum state and that the state of dispersion of the compounds over the surface of the substrates 300 can become uniform. More detailedly, the substrates 300 are disposed at such positions where the circles formed at the ends of the inverse cones of dispersing upward of the Group III compound and so forth fed from the nozzle openings 14 intersect with one another and where the distribution state of gas molecules arriving at the substrates 300 and the collision velocity thereof are sufficient for deposition of the gas molecules on the surface of the substrates 300 at an appropriate rate. Alternatively, the vacuum in the vacuum chamber 200, the rate of feeding of the gaseous compound or compounds and/or the number, diameter and/or some other factor of the openings 26 and 34 and/or the nozzle openings 14 is adjusted depending on the predetermined fixed distance between the nozzle openings 14 and the substrates 300. Such measures should be taken so that semiconductor layers having a thickness within the range of a specified thickness ± 5%, more preferably within the range of a specified thickness ± 1%, can be obtained. Generally, the higher the temperature of the substrates 300, the more quickly the reaction proceeds in the formation of GaAs from TEGa and AsH$_3$, for instance. However, when the substrate temperature is excessively high, the material is re-evaporated from layers once formed, whereby the layer growth rate is decreased. Therefore, the temperature of the substrates 300 should preferably be adjusted within the range of 500-700°C, more preferably 600-650°C. The vacuum condition in the reaction chamber 10 should preferably be less than $1,33 \times 10^{-4}$ Pa ($10^{-6}$ torr). The relationships among various conditions, for example feed rates for TEGa, AsH$_3$, etc., temperature of substrates 300, and so forth may be described in terms of the following equations (1), (2) and (3):

$$\frac{f_{As_2}}{f_{Ga}} = \frac{\Delta F}{2F_{Ga}} \times \frac{A}{a} \qquad \ldots (1)$$

where "f" is the beam flux of the subscripted material, F is the flow rate, A is the deposition area and a is the area of the exhaust ports 20. This area a of exhaust ports 20 should preferably amount to about 4% of the deposition area A. When the area a exceeds 4% of A, the Group V compound is exhausted excessively, whereby the distribution state within the reaction chamber 10 becomes no more uniform. As a result, the uniformity of the semiconductor layers obtained will be inferior. When the a/A ratio is below 4%, the flow of the Group V compound from within the reaction chamber 10 to the exterior becomes worsened and the efficiency of utilization of the Group III compound is decreased. As a result, efficient semiconductor layer deposition will be effected any longer. The equation (1) indicates that the density ratio between As$_2$ and Ga is proportional to the product of the ratio between the deposition area A and the area a of exhaust ports 20 and the ratio between the flow

rate ratio between AsH$_3$ and TEGa.

$$\lambda = kTV_b/\pi d_a^2 V_h P \qquad (2)$$

where $\lambda$ is the mean free path for the Group III compound, $d_a$ is the average diameter of the molecules colliding with the substrates 300, T is the temperature, $V_b$ is the velocity of beam molecules of the Group III compound fed through the nozzle openings 14, and $V_h$ is the velocity of molecules of the Group V compound heated in the vicinity of the substrates 300. An appropriate geometry of the reaction chamber 10 can be designed on the basis of this equation (2). It is important that the distance from the nozzle openings 14 to the substrates 300 should be smaller than the mean free path $\lambda$ for the Group III compound and at the same time such that the Group V compound can be distributed uniformly on the surface of the substrates 300.

The pressure drop within the reaction chamber 10 between the central portion thereof and the exhaust ports 20 should be smaller as compared with the difference in pressure between the inside of the reaction chamber 10 and the outside thereof across the exhaust ports 20. For instance, when the length of the reaction chamber 10 is equal to the width thereof, the ratio between the conductance Ca from the central part of the reaction chamber 10 to the side wall side and the conductance Co outside the reaction chamber 10 can be expressed by the following equation (3):

$$C_a/C_o = 4h^2/a \qquad (3)$$

where h is the nozzle opening 14 to substrate 300 distance, and a is the exhaust port 20 area. In this relation, the $C_a/C_o$ ratio should preferably amount to 4. In other words, the pressure variation across the reaction chamber 10 should preferably be not more than about 25%. Furthermore, the Group V compound should preferably be supplied in sufficient excess to render this pressure variation within the reaction chamber 10 insignificant. Even in that case, the consumption of the Group V compound can be reduced to about 1/20 as compared with the conventional MOCVD process.

As mentioned above, this apparatus for continuous production of semiconductors can perform different treatments in a continuous manner while transferring stepwise the substrate 300 to the reaction chamber 10 disposed in each of the three zones 100a, 100b and 100c resulting from division of the vacuum chamber 200 into three. Therefore, it can produce semiconductors very efficiently. Since each zone 100a, 100b, 100c has its reaction chamber 10 and the substrates 300 are treated in said reaction chamber 10, the reactant gases can be used effectively and, furthermore, different compounds may be used in the respective reaction chambers 10 in the zones 100a, 100b and 100c. Thus, the efficiency of reactant gas utilization can be improved and quality deterioration of semiconductor layers which may be caused by contamination of a compound with a different compound or compounds as impurities can be avoided or prevented.

In the above embodiment, it is also possible that each reaction chamber 10 have a cylindrical form and accordingly each top plate 18 have the corresponding circular form and that the top plates each can move independently to the next reaction chamber slowly and rotatedly around the central axis of the reaction chamber 10 system. This makes it easy to attain increased uniformity of semiconductor layers. While three reaction chambers 10 of the same geometry are used in the above embodiment, it is also possible to fabricate multilayer semiconductors by adding an additional reaction chamber or chambers and accordingly increasing the number of treatment steps. It is further possible to perform heating and cooling in separate chambers. The transfer of the substrates 300 to the next reaction chamber can be conducted not only by rotating the rotatable disc 61 with the top plates 18 mounted thereon, as in the above embodiment, but also by any other adequate means. For example, each base plate 12 with the surrounding walls 16 may be moved to the next reaction chamber position while the top plates 18 and mixing chambers are fixedly positioned. Furthermore, in one of possible modifications, the reaction chamber 10 for use in the first zone 100a may be lacking in nozzles and the like but is capable of heating and cooling alone, while the reaction chambers for use in the remaining zones 100b and 100c may have only one mixing chamber or three mixing chambers (when an additional mixing chamber is added below the second mixing chamber) depending on the treatments to be performed there. When, in the apparatus in the above embodiment and in the apparatus shown in Fig. 1, an additional mixing chamber is disposed, the exhaust valve 36 may be located either in the lowermost mixing chamber alone or in each of the mixing chambers. While, in both of said apparatus, the mixing chambers 24 and 30 are separated from each other and serve for feeding different starting material gases to the reaction chamber 10 via the nozzle openings 14 in communication with the respective mixing chambers, it is also possible to bring the mixing chambers 24 and 30 into communication with each other by means of holes or the like so that the starting material gases supplied from the starting material inlets 22 and 28 can be mixed in the mixing chamber 24 and then fed to the reaction chamber 10. It is further possible to provide the mixing chamber or chambers with a cooling jacket or the like to thereby cool the gaseous compound or compounds to an appropriate temperature by supplying cooling water to said jacket or the like. Said means serves for preventing excessive temperature rises in the gaseous compound or compounds and premature reactions of said compounds.

The apparatus in the foregoing embodiment and the apparatus shown in Fig. 1 each has two mixing chambers 24 and 30 for each reaction chamber 10, as mentioned above, and therefore can be used in a variety of modes because a plurality of different compounds can be fed through the respective nozzles. Furthermore, since the substrates 300 are heated from above by means of the heater 44 disposed over the top plate 18 while the gaseous compounds for semiconductor deposition are fed to the substrates 300 from below, adequate treatments can be realized and efficient deposition of good-quality semiconductor layers can be caused without any influence due to convectional gas flow resulting from heat generation by the heater 44. In addition, since the rate of compound flow within the reaction chamber is rendered constant as a result of exhaustion of unreacted gaseous compounds from the reaction chamber 10 via the exhaust ports 20 and since the feed tube 42 is disposed in a position which splits a plurality of nozzle openings 14, which are in communication with the mixing chambers 24 and 30, into equal halves, the Group V compound and so on can be fed to the surface of the substrates 300 in a uniformly mixed state, so that semiconductor layers of a Group III-V compound can be deposited uniformly. It is further possible for the apparatus of Fig. 1 to feed gaseous compounds the substrates 300 intermittently since there is provided the exhaustion valve 36 in the second mixing chamber 30. The use of TEAs, which is relatively low in toxicity, as the Group V compound can facilitate post-reaction treatment thereof for disposal. The fact that no carrier gas is used minimizes the gas quantity required and this also facilitates the waste disposal treatment.

## Claims

1. Apparatus for the production of semiconductors by a process in which semiconductor layers are deposited on the surface of at least one substrate in a vacuum chamber, the apparatus comprising: a reaction chamber (10); a substrate holder in the top wall (18) of the reaction chamber for holding a substrate (300) so that the face of the substrate is directed into the reaction chamber; a feed tube (42) for feeding a first reactant gas for semiconductor layer deposition to the reaction chamber from below towards the substrate; a heater (44) for heating the substrate disposed above the substrate holder;

a vacuum chamber (200) which can be evacuated to a high degree disposed around the reaction chamber to form a double structure, the reaction chamber being in fluid communication with the vacuum chamber through exhaust ports (20) in the walls (16) of the reaction chamber; a mixing chamber (24) disposed below the reaction chamber and in communication therewith through openings (14) in the adjacent walls (12) of the said two chambers; and an inlet tube (22) for supplying a second reactant gas to the mixing chamber.

2. Apparatus according to claim 1 in which the substrate holder is provided with an opening (18a) of slightly smaller diameter than the diameter of the substrate, the opening having a holding part (18b) around its circumference.

3. Use of the apparatus according to claim 1 or 2 for producing semiconductors in which semiconductor layers are deposited on the surface of at least one substrate in a vacuum chamber.

4. Use according to claim 3 characterized by heating the substrate indirectly through a heat distributer disposed between the beater and the substrate.

5. Use according to claim 3 or 4 characterized by heating the substrate and heating, cooling or depositing the semiconductor layers in a plurality of independent zones within the vacuum chamber; transferring the substrate to another of the plurality of independent zones stepwise to be able to perform a different treatment whereby a plurality of substrates may be treated simultaneously, each in a separate zone.

**Patentansprüche**

1. Vorrichtung zur Herstellung von Halbleitern durch ein Verfahren, bei dem Halbleiterschichten auf die Oberfläche wenigstens eines Substrates in einer Vakuumkammer abgelagert werden, wobei die Vorrichtung umfaßt: eine Reaktionskammer (10); einen Substrathalter in der Deckelwand (18) der Reaktionskammer, zum Halten des Substrates (300), so daß die Stirnfläche des Substrates in die Reaktionskammer gerichtet ist; ein Zufuhrrohr (42) zur Zufuhr eines ersten Reaktionsgases für Halbleiterschichtablagerung in die Reaktionskammer von unten zum Substrat; eine über dem Substrathalter angeordnete Heizvorrichtung (44) zum Erhitzen des Substrates; eine um die Reaktionskammer herum zur Bildung einer Doppelstruktur angeordnete Vakuumkammer (200), die zu einem hohen Grad evakuiert werden kann, wobei die Reaktionskammer über Auslaßöffnungen (20) in der Wand (16) der Reaktionskammer mit der Vakuumkammer in Fluidverbindung steht; eine Mischkammer (24), die unter der Reaktionskammer angeordnet ist und durch Öffnungen (14), in der an beide Kammern angrenzenden Wand (12), mit dieser in Verbindung steht; und ein Einlaßrohr (22) zur Zufuhr eines zweiten Reaktionsgases in die Mischkammer.

2. Vorrichtung nach Anspruch 1, dadurch gekennzeichnet, daß der Substrathalter mit einer Öffnung (18a) von geringfügig kleinerem Durchmesser als der Durchmesser des Substrates, wobei die Öffnung um ihren Umfang herum ein Halteteil (18b) aufweist.

3. Verwendung der Vorrichtung nach Anspruch 1 oder 2 zur Herstellung von Halbleitern, wobei Halbleiterschichten an der Oberfläche mindestens eines Substrates in der Vakuumkammer abgelagert werden.

4. Verwendung nach Anspruch 3, gekennzeichnet durch indirekte Erhitzung des Substrats mittels eines zwischen der Heizvorrichtung und dem Substrat angeordneten Hitzeverteilers.

5. Verwendung nach Anspruch 3 oder 4, gekennzeichnet durch Erhitzung des Substrats und Erhitzung, Abkühlung und Ablagerung der Halbleiterschichten in einer Mehrzahl von unabhängigen Zonen innerhalb der Vakuumkammer und schrittweiser Transport des Substrates zu einer anderen der Mehrzahl von unabhängigen Zonen, wodurch eine Mehrzahl von Substraten gleichzeitig behandelt werden können, jedes in einer separaten Zone.

**Revendications**

1. Appareil destiné à la production de semi-conducteurs par un procédé dans lequel on dépose des couches de semi-conducteurs à la surface d'au moins un substrat dans une enceinte sous vide, l'appareil comprenant : une enceinte réactionnelle 10 ; un support de substrat dans la paroi supérieure 18 de l'enceinte réactionnelle pour maintenir un substrat 300 de façon que la face de celui-ci soit dirigée dans la chambre réactionnelle ; un tube d'alimentation 42 destiné à alimenter un premier gaz réactif pour la déposition de la couche de semi-conducteurs dans la chambre réactionnelle à partir du dessous vers le substrat ; un dispositif de chauffage 44 destiné à chauffer le substrat disposé au-dessus du support de substrat ; une enceinte sous vide 200 pouvant être portée à un vide très poussé, disposée autour de l'enceinte réactionnelle pour former une double structure, l'enceinte réactionnelle étant en communication de fluides avec l'enceinte sous vide par des orifices d'échappement 20 dans les parois 16 de l'enceinte réactionnelle ; une enceinte de mélange 24 disposée au-dessous de l'enceinte réactionnelle et en communication avec celle-ci par les ouvertures 14 dans les parois contigües 12 de ces deux enceintes ; et un tube d'admission 22 destiné à amener un second gaz réactif dans l'enceinte de mélange.

2. Dispositif selon la revendication 1 dans lequel le support de substrat est muni d'une ouverture (18a) d'un diamètre légèrement plus petit que le diamètre du substrat, l'ouverture ayant une partie de support (18b) autour de sa circonférence.

3. Utilisation de l'appareil selon la revendication 1 ou 2, destinée à la production de semi-conducteurs dans lequel des couches de semi-conducteurs sont déposées à la surface d'au moins un substrat dans une enceinte sous vide.

4. Utilisation selon la revendication 3, caractérisée par le chauffage d'un substrat indirectement par un distributeur de chaleur disposé entre le dispositif de chauffage et le substrat.

5. Utilisation selon la revendication 3 ou 4, caractérisée par le chauffage du substrat, et le chauffage, le refroidissement ou le dépôt des couches de semi-conducteurs dans une pluralité de zones indépendantes à l'intérieur de l'enceinte sous vide ; le transfert des substrats vers une autre des différentes zones indépendantes progressivement pour permettre la réalisation d'un traitement différent, ce en quoi la pluralité de substrats peut être traitée simultanément, chacun dans une zone séparée.

F I G .1 (a).

F I G .1 (b).

F I G .2.

F I G .3.

300      18

16a    20

26    34    12    20

16

F I G .4.

53

51   300   18   50   52     200

P

10

F I G .5.

12,16

34

26

42b    42    42a

F I G .6.

A

100a

100c

50

200

100b

A'

# F I G .7.

# F I G .8.

## F I G .9.

## F I G .10.

F I G .11.